(19) **Europäisches Patentamt / European Patent Office / Office européen des brevets**

(11) **EP 2 434 304 B1**

(12) **FASCICULE DE BREVET EUROPEEN**

(45) Date de publication et mention
de la délivrance du brevet:
**24.07.2013 Bulletin 2013/30**

(51) Int Cl.:
***G01R 31/36*** *(2006.01)*

(21) Numéro de dépôt: **11290431.3**

(22) Date de dépôt: **23.09.2011**

(54) **Système et procédé de diagnostic in situ de batteries par spectroscopie d'impédance électrochimique**

Verfahren und System zur in situ Batteriediagnose mittels elektrochemischer Impedanzspektroskopie

System and method of in situ battery diagnosis by electrochemical impedance spectroscopy

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.09.2010 FR 1003820**

(43) Date de publication de la demande:
**28.03.2012 Bulletin 2012/13**

(73) Titulaire: **IFP Energies Nouvelles**
**92852 Rueil Malmaison Cedex (FR)**

(72) Inventeurs:
- **Mingant, Rémy**
**38200 Vienne (FR)**
- **Bernard, Julien**
**69600 Oullins (FR)**
- **Sauvant-Moynot, Valérie**
**69006 Lyon (FR)**

(56) Documents cités:
**EP-A1- 2 071 345    WO-A1-99/66340**
**WO-A2-03/071617    US-A1- 2004 006 440**
**US-A1- 2009 096 459**

- **RODRIGUES S ET AL: "A review of state-of-charge indication of batteries by means of a.c. impedance measurements", JOURNAL OF POWER SOURCES, ELSEVIER SA, CH, vol. 87, no. 1-2, 1 avril 2000 (2000-04-01), pages 12-20, XP004194179, ISSN: 0378-7753, DOI: DOI: 10.1016/S0378-7753(99)00351-1**
- **HUET ET AL: "A review of impedance measurements for determination of the state-of-charge or state-of-health of secondary batteries", JOURNAL OF POWER SOURCES, ELSEVIER SA, CH, vol. 70, no. 1, 30 janvier 1998 (1998-01-30), pages 59-69, XP005907566, ISSN: 0378-7753, DOI: DOI:10.1016/S0378-7753(97)02665-7**

**Description**

La présente invention concerne un procédé d'estimation de l'état interne d'un système électrochimique de stockage d'énergie électrique, tel qu'une batterie (Plomb, Ni-MH, Li-ion...). Le procédé permet de gérer des batteries utilisées dans des applications stationnaires ou embarquées, et notamment pendant leur fonctionnement.

La batterie est un des composants les plus critiques dans le cas des applications véhicules hybrides ou électriques. Le fonctionnement correct de ces applications s'appuie sur un système intelligent de gestion de la batterie (BMS pour "Battery Management System") qui s'occupe de faire fonctionner la batterie au meilleur compromis entre les différents niveaux de sollicitation dynamique. Ce BMS requiert la connaissance précise et fiable de l'état de charge (SoC) et de l'état de santé (SoH).

L'état de charge d'une batterie (SoC) correspond à sa capacité disponible, et s'exprime en pourcentage de sa capacité nominale indiquée par le fabricant, ou encore en pourcentage de sa capacité totale mesurée dans des conditions données lorsque cette mesure est possible. La connaissance du SoC permet d'estimer le temps durant lequel la batterie pourra continuer à fournir de l'énergie à un courant donné avant la recharge suivante, ou jusqu'à quand elle pourra en absorber avant la décharge suivante. Cette information conditionne le fonctionnement des systèmes utilisant des batteries.

Pendant la vie d'une batterie, ses performances tendent à se dégrader graduellement à cause des variations physiques et chimiques qui ont lieu avec son usage, jusqu'à la rendre inutilisable. L'état de santé (SoH) représente l'état d'usure d'une batterie. Ce paramètre correspond à la capacité totale d'une batterie à un instant $t$ au cours de sa vie de service, et s'exprime en pourcentage de la capacité totale déterminée en début de vie, équivalente à la capacité nominale indiquée par le fabricant, ou encore à la capacité mesurée en début de vie dans des conditions données.

Une estimation précise et fiable du SoC et du SoH, pour un véhicule, permet par exemple d'éviter que le superviseur du véhicule ne soit amené à se comporter d'une façon trop prudente dans l'utilisation du potentiel d'énergie de la batterie, ou inversement. Un mauvais diagnostic d'état de charge peut conduire à surestimer le nombre de kilomètres pouvant être parcourus, et mettre alors l'automobiliste en difficulté. Une bonne estimation de ces indicateurs permet aussi d'éviter des surdimensionnements de sûreté des batteries, donc de sauvegarder du poids à bord et, en conséquence, du carburant consommé. L'estimation du SoC et du SoH permet également de réduire le coût total du véhicule. Un outil de diagnostic du SoC et du SoH correct constitue donc une garantie pour une exploitation efficace, sûre et pérenne de la capacité de la batterie dans toute la plage de fonctionnement du véhicule.

**État de la technique**

Plusieurs procédés d'estimation de l'état de charge (SoC) et de l'état de santé (SoH) d'une batterie sont connus.

On connait par exemple les procédés "coulomb-counting" ou "book-keeping". Mais ces procédés conduisent à des erreurs d'estimation en négligeant des phénomènes comme l'autodécharge. On connait également un procédé dans lequel on mesure la tension à vide comme indicateur du SoC. L'usage d'autres indicateurs, par exemple l'estimation d'une résistance interne (brevets US6191590 B1, EP1835297 A1) est une méthode également connue.

Ces deux procédés sont caractérisés par le fait que le SoC est préalablement associé à une ou plusieurs quantités mesurables ou facilement estimables (potentiel, résistance interne), à travers des cartographies statiques ou des dépendances fonctionnelles analytiques. Pourtant, ces dépendances sont en réalité beaucoup plus compliquées que ce qui est normalement pris en compte dans le BMS, ce qui amène souvent à des erreurs dans l'estimation du SoC.

Une autre approche se base sur des modèles mathématiques de batterie, afin d'utiliser des techniques d'estimation connues dans d'autres domaines. La demande de brevet US 2007/0035307 A1 décrit notamment une méthode pour estimer les variables d'état et les paramètres d'une batterie à partir des données de service (tension U, courant 1, T), utilisant un modèle mathématique de batteries. Le modèle mathématique est caractérisé par le fait qu'il comprend une pluralité de sous-modèles mathématiques, et permet une réponse plus rapide. Les sous-modèles sont des modèles de type circuit électrique équivalent, dit modèles RC, associés à des gammes de fréquences restreintes.

Une méthode potentiellement plus prometteuse est basée sur la mesure par spectroscopie d'impédance (SIE) d'une grandeur paramétrée par le SoC. Par exemple, la demande de brevet US 2007/0090843 propose de déterminer par SIE la fréquence f± associée à la transition capacitive/inductive. Une corrélation entre la fréquence f± et le SoC est présentée pour une batterie au plomb, ainsi que pour les batteries Ni-Cd et Ni-MH. Une approche similaire est basée sur la modélisation des spectres SIE par circuits électriques équivalents, dont les composants sont paramétrés par le SoC, comme décrit dans le document US6778913 B2, qui permettent le développement d'un testeur de batteries automobiles Spectro CA-12 (Cadex Electronics Inc., Canada) basé sur la spectroscopie d'impédance électrochimique à multifréquences pour le couple acide-plomb. Les spectres SIE sont approchés par des circuits électriques équivalents, et l'évolution des composants est paramétrée par le SoC. De même, dans le document US 6037777, on détermine l'état de charge et autres propriétés de batteries par la mesure des parties réelles et imaginaires de l'impédance/admittance complexe pour des batteries au plomb ou d'autres systèmes. L'utilisation de modèles RC est décrite également dans le document EP880710, la description des phénomènes électrochimiques et physiques aux électrodes et dans l'électrolyte servant de support au développement du modèle RC, la température de la batterie étant simulée par le modèle, afin de gagner en précision, par rapport à une mesure externe.

Autres examples sont les documents US 2004 006 440 A1, US 2009 096 459 A1 et WO 9 966 340 A1.

Concernant les méthodes d'estimation du SoH connue dans la littérature, on connait le document WO 2009/036444 dans lequel les auteurs introduisent une électrode de référence dans des éléments commerciaux afin d'observer les réactions de dégradation des électrodes. Cette méthode demande cependant une instrumentation importante, notamment pour insérer une électrode de référence à l'intérieur de l'élément, ainsi qu'une gestion électronique plus complexe de la batterie.

Le document FR2874701 décrit une méthode utilisant une perturbation électrique temporelle afin de comparer la réponse obtenue à une réponse de référence. Cependant, cette méthode est plus difficile à mettre en oeuvre pour des éléments type li-ion dont les variations de réponse suite à ce type de perturbation sont très faibles, et donc ne peuvent donner lieu à une mesure de SoH précise.

Des analyses par impédance ont également été décrites dans la littérature. U. Tröltzsch et al (Electrochimica Acta 51, 2006, 1664-1672) décrivent une méthode dans laquelle ils utilisent la spectroscopie d'impédance, couplée à l'ajustement des impédances selon un modèle électrique pour obtenir l'état de santé de l'élément. Cette technique requiert cependant un arrêt de l'utilisation de l'élément pour la mesure.

Ainsi, l'objet de l'invention concerne un procédé alternatif pour estimer un état interne d'un système électrochimique de stockage d'énergie électrique, tel qu'une batterie, sans utiliser de modélisation par circuit électrique équivalent. Le procédé se base directement sur un modèle d'impédance électrochimique, permettant de définir cette impédance en fonction du SoC par exemple, et de paramètres. Ces paramètres sont calibrés au moyen d'un ajustement sur des mesures d'impédance électrochimique obtenues antérieurement pour des états internes différents.

**Le procédé selon l'invention**

L'invention concerne un procédé d'estimation d'un état interne d'au moins un premier système électrochimique de stockage d'énergie électrique, dans lequel on estime au moins une propriété relative à l'état interne dudit premier système électrochimique à partir de mesures d'impédance électrochimique, comportant les étapes suivantes :

- pour différents états internes d'au moins un second système électrochimique d'un même type que ledit premier système électrochimique : - on mesure ladite propriété relative à l'état interne dudit second système; et - on mesure l'impédance électrochimique dudit second système électrochimique à au moins une fréquence ;

- on définit un modèle d'impédance électrochimique en fonction de ladite propriété et de paramètres, et l'on calibre lesdits paramètres au moyen d'un ajustement sur lesdites mesures d'impédance électrochimique obtenues pour lesdits états internes ;

- on détermine une impédance électrochimique **Z** dudit premier système électrochimique pour au moins une fréquence ;

- on estime l'état interne dudit premier système électrochimique en estimant ladite propriété relative à l'état interne dudit système électrochimique au moyen dudit modèle et de ladite impédance électrochimique **Z.**

Selon l'invention, on peut estimer la propriété relative à l'état interne dudit système électrochimique au moyen des étapes suivantes :

i. on choisit une valeur initiale pour ladite propriété ;

ii. on applique ledit modèle à ladite valeur initiale pour modéliser une impédance électrochimique **Zm** dudit premier système pour au moins une fréquence ;

iii. on ajuste ladite valeur de façon à ce que l'impédance électrochimique modélisée **Zm** corresponde à l'impédance électrochimique mesurée **Z.**

Selon l'invention, on peut construire ledit modèle d'impédance électrochimique en réalisant les étapes suivantes :

i. on choisit une forme de courbe représentative de diagramme d'impédance obtenu sur un système électrochimique d'un même type que ledit premier système électrochimique ;
ii. on définit ledit modèle par une formule permettant de reproduire ladite forme de courbe.

On peut utiliser un modèle du type:

$$Zm = a * i * \omega + b + \sum_{k=1}^{k=x} \frac{1}{c_k + d_k * i * \omega^{n_k}}$$

avec :

- Zm : impédance électrochimique
- $\omega$ : fréquence
- x : nombre de demi-cercles formés par ladite courbe
- a, b, $C_k$, $d_k$ et $n_k$ : paramètres du modèle à calibrer, dépendant de ladite propriété relative à l'état interne dudit premier système électrochimique.

Les différents états internes peuvent être obtenus en réalisant un vieillissement accéléré d'un second système électrochimique de stockage d'énergie électrique d'un même type que ledit premier système électrochimique. Ces différents états internes peuvent également être obtenus en sélectionnant un ensemble de seconds systèmes électrochimiques du même type que ledit premier système électrochimique, lesdits systèmes dudit ensemble ayant des états internes différents.

Selon l'invention, on peut calculer au moins l'une des propriétés relatives à l'état interne dudit système électrochimique suivantes : un état de charge (SoC) dudit système, un état de santé (SoH) dudit système.

On peut déterminer l'impédance électrochimique pour différentes fréquences en mesurant des diagrammes d'impédance électrique obtenue par ajout d'un signal électrique à un courant traversant ledit système électrochimique. Pour ce faire, on peut mesurer lesdits diagrammes d'impédance électrique en appliquant une perturbation sinusoïdale en courant sur ledit système électrochimique, et en mesurant une tension sinusoïdale induite aux bornes dudit système électrochimique. On peut également mesurer lesdits diagrammes d'impédance électrique en appliquant une perturbation en courant sous la forme d'une superposition de plusieurs sinusoïdes ou sous la forme d'un bruit blanc, sur ledit système électrochimique, et en mesurant une tension sinusoïdale induite aux bornes dudit système électrochimique. Enfin, on peut encore déterminer l'impédance électrochimique pour différentes fréquences en mesurant des diagrammes d'impédance électrique obtenus au moyen d'un procédé non intrusif comportant un traitement du signal de tension et de courant en fonction du temps.

Selon l'invention le système électrochimique peut être au repos ou en fonctionnement, et ledit système électrochimique peut être une batterie ou un élément d'un pack.

Selon l'invention, il est possible de détecter une défaillance d'au moins un élément d'un pack de batterie en déterminant l'état de fonctionnement (SoF) d'au moins un élément dudit pack.

L'invention concerne également un système d'estimation d'un état interne d'un système électrochimique de stockage d'énergie électrique, comportant :

- au moins un capteur (G) incluant un moyen de mesure ou d'estimation d'impédance électrochimique dudit système électrochimique ;

- une mémoire permettant de stocker un modèle d'impédance électrochimique en fonction de ladite propriété, ledit modèle étant préalablement calibré au moyen de mesures pour différents états internes d'au moins un second système électrochimique d'un même type que ledit système électrochimique ;

- des moyens pour calculer une propriété relative à l'état interne dudit système électrochimique au moyen dudit modèle.

L'invention concerne également un système intelligent de gestion ou de charge / décharge d'une batterie comportant un système d'estimation d'un état interne de ladite batterie selon l'invention.

D'autres caractéristiques et avantages du procédé et des systèmes selon l'invention, apparaîtront à la lecture de la description ci-après d'exemples non limitatifs de réalisations, en se référant aux figures annexées et décrites ci-après.

**Présentation succincte des figures**

- La figure 1 représente le logigramme du procédé selon l'invention appliqué à une batterie.

- La figure 2 illustre des diagrammes d'impédance pour différentes valeurs de SoC.

- la figure 3 illustre un diagramme d'impédance (diagramme de Nyquist) pour une batterie dont le SoC est d'environ 50%.

- La figure 4 illustre la tension U (en V) en fonction de la capacité de charge SoC normée.

- La figure 5A illustre des valeurs de SoC réellement mesurées (SoCr) en fonction des valeurs de SoC modélisées (SoCm) par la résolution de l'équation en impédance.

- La figure 5B illustre des valeurs de SoC réellement mesurées (SoCr) en fonction des valeurs de SoC modélisées (SoCm) par la résolution de l'équation en impédance et de l'équation en tension.

- La figure 6 présente, en représentation de Bode, une comparaison entre les impédances obtenues pour plusieurs états de charge à une température de 25°C, pour une batterie commerciale de type $C_6$/LiFePO$_4$

- La figure 7 présente, en représentation de Bode, un spectre d'impédance provenant de mesures expérimentales sur une batterie commerciale de type $C_6$/LiFePO$_4$ superposée aux valeurs de prédiction de l'ajustement fait selon un modèle mathématique.

- La figure 8A présente un paramètre (d2) obtenu par ajustement des impédances selon un modèle mathématique pour tous les SoC.

- La figure 8B présente le paramètre (d2) en fonction du SoC (ronds), Ainsi que la prédiction de cette même valeur selon un polynôme de degré 7 (trait).

- La figure 9 illustre un autre diagramme d'impédance (diagramme de Nyquist) pour une batterie dont le SoC est d'environ 50%.

- La figure 10 illustre des valeurs de SoC réellement mesurées (SoCr) en fonction des valeurs de SoC modélisées (SoCm) grâce à un modèle selon l'invention.

- La figure 11 représente le logigramme du procédé selon l'invention appliqué à plusieurs éléments d'une batterie.

**Description détaillée de l'invention**

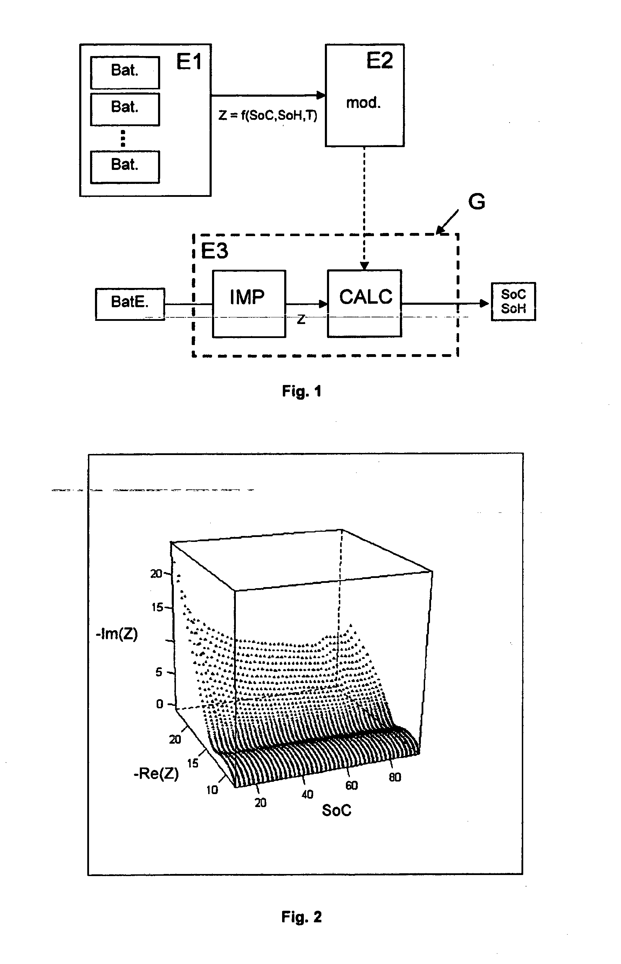

Le procédé selon l'invention permet de réaliser une jauge d'état de charge ou d'état de santé d'une batterie ou d'une cellule d'un pack, de modèle et de technologie préalablement identifiés, pour son utilisation dans une application transport (batterie de traction) ou pour le stockage des énergies renouvelables. Le principe proposé consolide les estimations de SoC et SoH faites par le BMS, ces données n'étant pas mesurables directement.
Le procédé est potentiellement embarqué dans un véhicule, ou utilisé pour stocker de l'énergie dans le cadre des systèmes de production intermittente d'électricité connectés au réseau, permettant de déterminer quantitativement l'état de charge (SoC) et l'état de santé (SoH) de batteries, et notamment de batteries Li-ion, à partir d'une mesure de l'impédance électrique aux bornes des électrodes du système, mesure non intrusive et à température contrôlée.
Le logigramme du procédé est représenté sur la figure 1. Le procédé selon l'invention comporte les étapes suivantes :

Étape E1 : On réalise une campagne d'essais en laboratoire sur un lot de batteries (Bat.) afin de mesurer l'impédance électrique (Z) en fonction de la fréquence, du SoC, du SoH et de T.

Étape E2 : On définit et calibre un modèle (mod.) de l'impédance Z.

Étape E3 : Le modèle défini et calibré est utilisé dans une jauge (G) pour estimer l'état interne d'une batterie (BatE) de même technologie et modèle que celles de l'étape E1. Cette jauge comprend en particulier un dispositif (IMP) de détermination de l'impédance et une unité de calcul (CALC) mettant en oeuvre le modèle mod.

Ces étapes sont décrites en détails dans les paragraphes qui suivent.

E1- Mesure de diagrammes d'impédance électrochimique en fonction de : SoC, SoH et T

Il s'agit de réaliser une campagne d'essais en laboratoire permettant de mesurer l'impédance électrochimique (Z) en fonction de la fréquence, du SoC, du SoH et éventuellement de la température T. On obtient ainsi des diagrammes d'impédance (Z) électrochimique en fonction du SoC (figure 2), du SoH et/ou de T. Les axes de la figure 2 représentent : la partie imaginaire de l'impédance, lm(Z), exprimée en mOhms, la partie réelle de l'impédance, Re(Z), exprimée en mOhms, et l'état de charge, SoC, exprimé en %.

De façon générale, pour différents états internes d'au moins un second système électrochimique d'un même type que le système électrochimique étudié : - on mesure la propriété relative à l'état interne du second système (SoC, SoH) ; et - on mesure la réponse électrique de ce second système électrochimique à différentes fréquences.

Selon un mode de réalisation, pour un type de batterie (BatE.) donné, et pour une application de cette batterie donnée, on utilise une batterie du même type (Bat.). Puis, on réalise des mesures de réponses électriques pour différents états de charge et de santé de cette batterie. Pour obtenir des états de santé différents de cette batterie, on peut réaliser un vieillissement accéléré représentatif de l'application visée. Par exemple, la batterie subit en laboratoire un protocole de vieillissement accéléré simulant une application embarquée de type véhicule.

La mesure des diagrammes d'impédance peut être obtenue par application d'une perturbation sinusoïdale en courant (de préférence) sur une batterie à l'aide d'un galvanostat et mesure de la tension sinusoïdale induite aux bornes. Selon un autre mode de réalisation, on peut appliquer ia perturbation sous la forme d'une superposition de plusieurs sinusoïdes ou même sous la forme d'un bruit blanc (où toutes les fréquences sont superposées dans le même signal), plutôt que sous la forme d'une perturbation sinusoïdale simple, ce qui permet d'analyser ensuite plusieurs ou toutes les réponses en fréquence en même temps.

La mesure des diagrammes d'impédance en fonction du SoC peut être faite sur la pleine plage de SoC, ou sur la plage de SoC correspondant à celle utilisée pour l'application.

La variation des diagrammes d'impédance avec la température sur la plage de température de fonctionnement de l'application peut également être mesurée.

A chaque état de charge et/ou de vieillissement, l'impédance électrique Z du système électrochimique est mesurée par application d'une perturbation en courant au moyen d'un galvanostat.

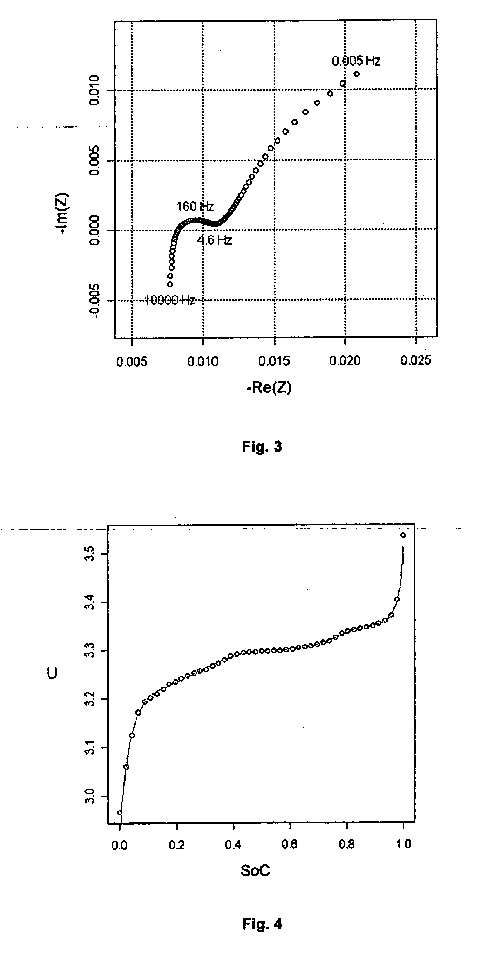

La grandeur Z complexe (de partie réelle ReZ et de partie imaginaire ImZ) peut être représentée sous la forme d'un diagramme de Nyquist, où lm(Z) est une fonction de ReZ, et où chaque point correspond à une fréquence. Un tel diagramme est illustré sur la figure 2 en fonction du SoC et sur la figure 3. On distingue ainsi les réponses des phénomènes rapides (résistance interne aux hautes fréquences), des phénomènes intermédiaires tels que les réactions aux électrodes, et des phénomènes lents (diffusion des ions dans le milieu aux basses fréquences traduite par une impédance de Warburg). Ces différents phénomènes sont plus ou moins sensibles aux SoC et SoH. Ainsi la réponse en impédance change en fonction de l'état de charge et du vieillissement ; une difficulté est de découpler les effets.

On a décrit l'utilisation d'une seconde batterie de même type que la batterie étudiée. On peut également utiliser un ensemble de batteries du même type. Chacune de ces batteries possédant un état de charge et/ou un état de santé différent.

E2- Définition d'un modèle de diagramme d'impédance

Au cours de cette étape, on définit une formule mathématique permettant de modéliser l'impédance en fonction de la fréquence ($\omega$) pour un état de charge donné SoC, un état de santé donné SoH et éventuellement une température donnée. Pour réaliser cette modélisation :

i. on effectue une sélection d'un diagramme d'impédance (Z) pour un SoC déterminé pour déterminer la forme de la courbe représentant le diagramme; puis,

ii. on définit une formule mathématique, le modèle, capable de reproduire cette forme de courbe ; enfin,

iii. on calibre les paramètres du modèle, de façon à ajuster le modèle sur des diagrammes d'impédance issus de mesures.

On sélectionne un diagramme d'impédance pour un SoC déterminé, à T donnée. Par exemple, la figure 3 illustre un diagramme d'impédance pour une batterie dont le SoC est d'environ 50%. La forme de la courbe de ce diagramme est caractéristique de diagramme d'impédance de batterie. En effet, un diagramme d'impédance forme une courbe comportant au moins un demi-cercle.

On peut modéliser une telle courbe par la formule suivante :

$$Z(\omega, \mathrm{SoC}, \mathrm{SoH}, T) = a * i * \omega + b + \sum_{k=1}^{k=x} \frac{1}{c_k + d_k * i * \omega^{n_k}}$$

Avec : Z l'impédance, $\omega$ la fréquence, x le nombre de demi-cercles observés, et a, b, $C_k$, $d_k$ et $n_k$ les paramètres du modèles. S'il y a trois cercles, le modèle comporte donc 1+1+3+3+3=11 paramètres. Tous les paramètres sont fonction du SoC, éventuellement du SoH, et éventuellement de la température T, voire d'autres variables v telles que la constitution de l'élément (matériaux d'électrodes, électrolyte,...). Ainsi de façon générale, on désigne par p un paramètre du modèle, et l'on a :

$$p = f(\mathrm{SoC}, \mathrm{SoH}, T, v) \quad \text{où f est une fonction polynomiale par exemple.}$$

Le modèle d'impédance électrique est ensuite calibré sur chaque diagramme d'impédance de la campagne d'essais correspondant à chaque état de SoC, SoH et température (T) de la batterie. La calibration consiste à donner une valeur aux paramètres a, b, $c_k$, $d_k$ et $n_k$.

Les paramètres sont calibrés par régression non linéaire à partir d'un algorithme de type NL2S (Non Linear Least Square). Cet algorithme permet de minimiser l'écart entre la prédiction du modèle, et les mesures expérimentales en faisant varier les paramètres d'ajustement.

E3. Estimation de l'état interne du système électrochimique au moyen de la relation.

On détermine l'impédance électrique du système électrochimique étudié pour différentes fréquences. Pour ce faire on mesure des diagrammes d'impédance électrique en utilisant l'une des méthodes suivantes :

- on mesure des diagrammes d'impédance électrique obtenue par ajout d'un signal électrique à un courant traversant le système électrochimique :

  - en appliquant une perturbation sinusoïdale en courant sur le système électrochimique, et en mesurant une tension sinusoïdale induite aux bornes du système électrochimique; ou

  - en appliquant une perturbation en courant sous la forme d'une superposition de plusieurs sinusoïdes ou sous la forme d'un bruit blanc, sur le système électrochimique, et en mesurant une tension sinusoïdale induite aux bornes dudit système électrochimique.

- On utilise un traitement du signal de courant libre, ou de fonctionnement, pour le système électrochimique. On peut utiliser le procédé décrit dans la demande de brevet FR 10/00.778. Il s'agit d'un procédé non intrusif de détermination de l'impédance électrique d'un système électrochimique sans surimposer de signaux supplémentaires. Selon ce procédé, on mesure la tension et le courant aux bornes du système en fonction du temps, et on transforme ces mesures en signaux fréquentiels. Puis on réalise au moins une segmentation de ces signaux fréquentiels en plusieurs segments. Pour chaque segment, on détermine la densité spectrale de puissance du signal de courant $\psi I$ et la densité spectrale de puissance croisée des signaux de tension et de courant $\psi IV$ sur chacun des segments. Enfin, on détermine l'impédance électrique du système électrochimique en calculant le rapport de la moyenne des densités spectrales de puissance $\psi I$ et la moyenne des densités spectrales de puissance croisées $\psi IV$.

Puis, on choisit une valeur initiale de SoC, et éventuellement une valeur de SoH et de température.

Ensuite, en appliquant le modèle de l'impédance électrique construit à l'étape 2, sur la ou les valeurs initiales, on compare sur un diagramme l'impédance modélisée à l'impédance déterminée. Les valeurs initiales des paramètres (SoC, SoH, T) sont alors ajustées jusqu'à ce que le diagramme d'impédance modélisé corresponde au diagramme d'impédance mesuré.

Pour ce faire, on peut utiliser un algorithme d'optimisation tel que l'algorithme NL2S (non linear least square), dit des moindres carrés, dont le principe est de minimiser la somme des carrés des écarts entre mesure et modèle.

Dans cet algorithme, la différence entre le diagramme d'impédance modélisé et le diagramme d'impédance mesuré peut être calculée de la façon suivante :

$$S = \sum_{i=1}^{N} (Y_i - Ycalc_i)^2$$

S est la somme des carrés des écarts à minimiser, Y, est un vecteur de taille N constitué de toutes les mesures à ajuster, Ycalc, est un vecteur de taille N constitué de toutes les mesures prédites.

La ou les valeurs ainsi déterminées par le processus d'optimisation, constituent une estimation de l'état interne du système électrochimique.

Selon l'invention, le modèle obtenu à l'étape précédente est utilisé dans un système d'estimation d'un état interne d'un système électrochimique de stockage d'énergie électrique, comportant :

- au moins un capteur (G) incluant un moyen de mesure ou d'estimation d'impédance électrochimique du système électrochimique. Ce système de mesure de l'impédance (*IMP*) peut utiliser indifféremment une méthode décrite à l'étape 1. Ce système de mesure de l'impédance peut être remplacé par un système d'estimation de l'impédance, tel que le système décrit dans la demande de brevet français 10/00.778.

- une mémoire permettant de stocker un modèle d'impédance électrochimique en fonction de la propriété, le modèle étant préalablement calibré au moyen de mesures pour différents états internes ;

- des moyens logiciels (CALC) comportant :

  o des moyens de calcul de l'impédance si le système de mesure ne l'intègre pas,
  o des moyens de calcul, un optimiseur (OPT), de la propriété relative à l'état interne du système électrochimique au moyen du modèle.

L'invention concerne également un système intelligent de gestion d'une batterie comportant un système d'estimation d'un état interne de la batterie ou d'un élément tel que décrit précédemment.

Ce système intelligent de gestion peut être un système de charge ou un système de décharge d'une batterie.

**Variantes**

Selon un mode de réalisation, on mesure les impédances électrochimiques pour une seule fréquence, et non plusieurs. Cette fréquence est choisie de préférence dans les basses fréquences.

Selon un autre mode de réalisation, on utilise d'autres variables évoluant (peu) en fonction du SoC. De façon avantageuse, on utilise la tension aux bornes de la batterie. La figure 4 illustre la tension U (en V) en fonction de la capacité de charge SoC normée. Les points représentent des mesures. La courbe représente un ajustement de type polynômial. On peut également ajuster ces points de mesure par une équation thermodynamique de type redlich-kister ou margoule.

On obtient ainsi une équation du type U=f(SoC, T).

Selon ce mode de réalisation, on détermine les paramètres du modèle de diagramme d'impédance, en résolvant le système suivant :

$$\begin{cases} Z = a * i * w + b + \dfrac{1}{c_1 + d_1 * i * w^{n_1}} + \dfrac{1}{c_2(SoC,T) + d_2(SoC,T) * i * w^{n_2}} \\ U = f(SoC,T) \end{cases}$$

Pour résoudre ce système, on peut utiliser un algorithme de type NL2S (Non Linear Least Square).

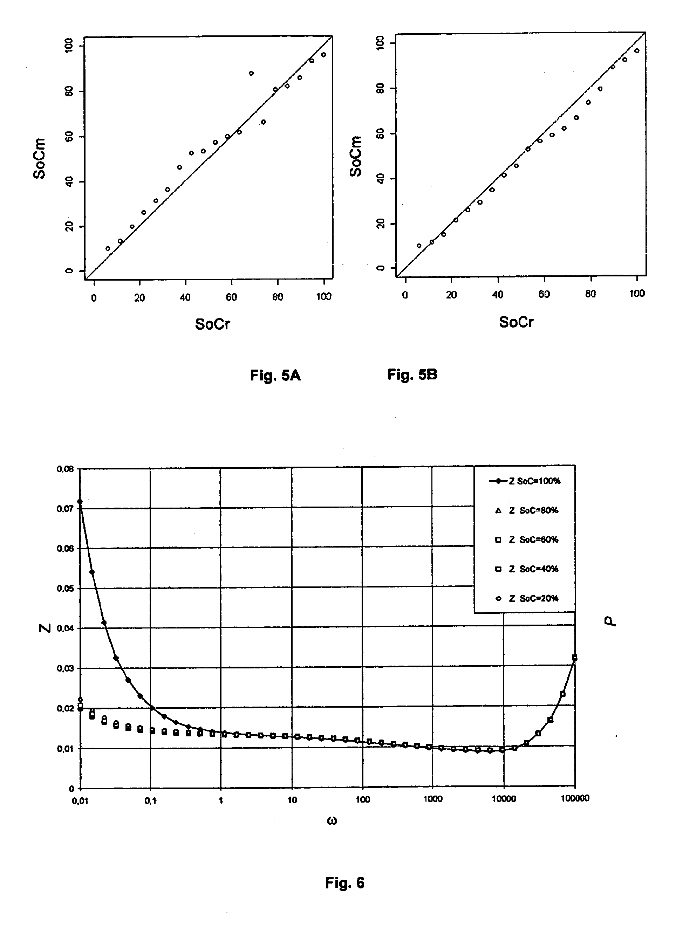

Les figures 5A et 5B illustrent l'avantage de ce mode de réalisation. La figure 5A illustre des valeurs de SoC réellement mesurées (SoCr) en fonction des valeurs de SoC modélisées (SoCm) par la résolution de l'équation en impédance. La figure 5B illustre des valeurs de SoC réellement mesurées (SoCr) en fonction des valeurs de SoC modélisées (SoCm) par la résolution de l'équation en impédance et de l'équation en tension. On constate un meilleur ajustement sur la figure 5B.

Ainsi, le procédé selon l'invention, permet d'obtenir un outil fiable de détermination de l'état de charge ou de l'état de santé d'un élément Li-ion. Ce procédé est applicable à toutes les technologies, et les paramètres du modèle pouvant varier en fonction de la dispersion sont inclus dans le calcul (et non figés). Enfin, selon ce procédé, il est possible de prendre en compte la température, ainsi que tout paramètre pouvant influencer sur la réponse en impédance de la batterie.

A titre d'exemples, les étapes du procédé selon l'invention sont appliquées à deux technologies de batteries ou accumulateurs Li-ion différentes : une technologie LFP/C (LFP indiquant une électrode positive à base de phosphate de fer, C une électrode négative à base de graphite), une technologie NCO/C (NCO indiquant une électrode positive à base de Nickel).

Exemple 1 : Cas d'un élément de chimie LFP/C

Étape 1

La figure 6 illustre un diagramme de Bode dans lequel $\omega$ représente la fréquence en Hz, P représente la phase en degrés, et Z représente le module de l'impédance électrochimique en Ohm. Ce diagramme permet de comparer les impédances déterminées pour plusieurs états de charge sur une batterie de type C/LFP. Ces impédances ont été obtenues en utilisant successivement des signaux sinusoïdaux de fréquences différentes. Les impédances peuvent aussi être obtenues de manière différente comme par exemple en superposant un bruit blanc aux signaux de charge/décharge des batteries.

Il est remarquable de constater sur le diagramme que les impédances ne sont pas superposées mais évoluent en fonction de la capacité chargée.

Étape 2

Ces différences sont quantifiées selon l'invention en ajustant un modèle d'impédance sur les courbes du diagramme d'impédance à l'aide de la formule suivante :

$$Z(\omega, \text{SoC}) = a * i * \omega + b + \frac{1}{c_1 + d_1 * i * \omega^{n_1}} + \frac{1}{c_2 + d_2 * i * \omega^{n_2}}$$

Où a, b, c1, d1, n1, c2, d2, n2 sont des paramètres à ajuster selon les valeurs expérimentales.

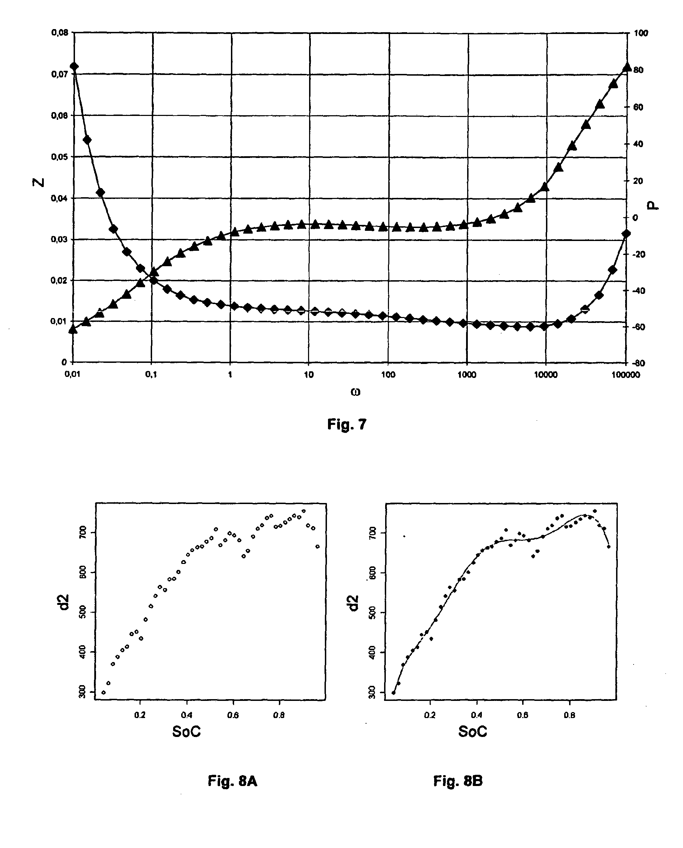

La qualité de l'ajustement peut être testée sur un diagramme de Nyquist ou de Bode pour un SoC et une température : sur la figure 7, les triangles (phase notée P) et losanges (module de l'impédance noté Z) représentent les valeurs expérimentales, et les traits pleins indiquent les valeurs ajustées. On constate que prédictions et mesures sont toutes superposées, ce qui témoigne d'un ajustement avec un modèle bien choisi, et des paramètres correctement estimés.

Après l'ajustement systématique de toutes les impédances déterminées expérimentalement en fonction du SoC et de T, seuls les paramètres c2, d2 et n2 relatifs au second demi cercle évoluent en fonction du SoC. La dépendance au SoC est illustrée sur la figure 8a pour le paramètre d2. Une fonction polynomiale est utilisée pour ajuster la dépendance au SoC des paramètres. Dans le cas de d2, un ajustement avec un polynôme de degré 7 permet d'obtenir une équation décrivant le tracé visible sur la figure 8B. Les autres paramètres peuvent être pris comme constants quel que soit l'état de charge de la batterie.

Au final, l'ensemble des ajustements effectués en fonction du SoC permettent d'obtenir un modèle prédisant l'impédance d'une batterie en fonction de la fréquence de perturbation, et du SoC.

Étape 3

On considère une batterie de même technologie et modèle que celles testées en étapes 1 et 2, de SoC connu. On détermine son impédance électrique par une mesure comme décrite dans les étapes 1 et 2, ou bien suivant le procédé décrit dans la demande de brevet français 10/00.778. L'algorithme d'optimisation basé sur le modèle selon l'invention permet d'estimer le SoC de la batterie à partir des mesures expérimentales (exemple sur la batterie de validation, figure 5A).

De manière avantageuse, la tension de l'élément en fonction du SoC (Figure 4) peut être utilisée pour obtenir une précision plus importante sur le SoC (exemple sur la batterie de validation, figure 5B)

Cas d'un élément de chimie NCO/C

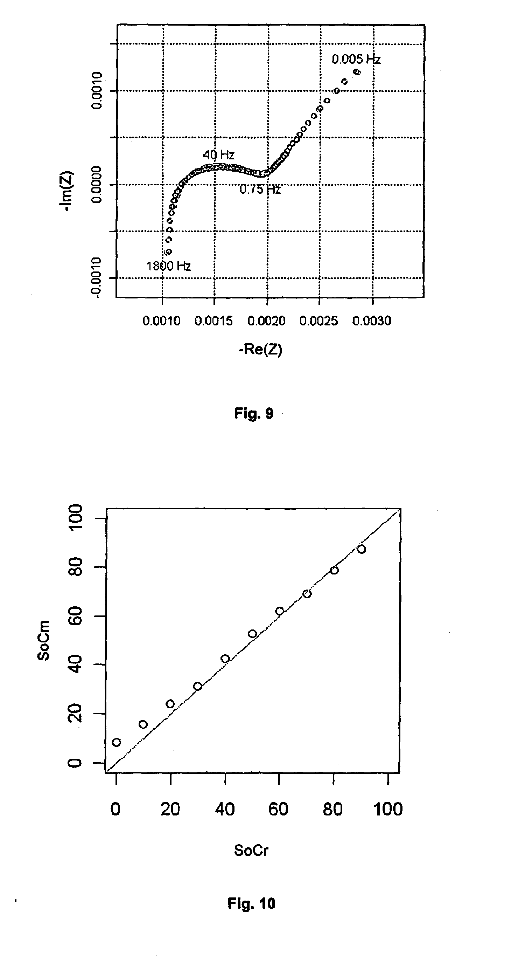

Ce nouvel exemple permet de vérifier la robustesse du procédé selon l'invention pour différentes technologies de batteries. Le diagramme d'impédance (diagramme de Nyquist) à 50% de SoC de la technologie NCO/C est présenté sur la figure 9. D'après la forme de cette courbe, on devine la convolution de 3 demi-cercles, ce qui permet de définir le modèle comme suit :

$$Z(\omega, SoC) = a * i * \omega + b + \frac{1}{c_1 + d_1 * i * \omega^{n_1}} + \frac{1}{c_2 + d_2 * i * \omega^{n_2}} + \frac{1}{c_3 + d_3 * i * \omega^{n_3}}$$

Où a, b, c1, d1, n1, c2, d2, n2, c3, d3, n3 sont des paramètres à ajuster selon les valeurs expérimentales.

En procédant de manière analogue à l'exemple précédent, ce modèle est ajusté sur les diagrammes d'impédance en fonction de la fréquence, de l'état de charge, et de la température et conduit à un modèle d'impédance en fonction du SoC, de la température, et de la fréquence.

En utilisant un autre élément de chimie identique, de SoC connu, et le modèle précédent, on peut calculer le SoC de cet élément à partir d'une détermination de son impédance électrique à T donnée. La figure 10 illustre les résultats : les valeurs de SoC réellement mesurées (SoCr) en fonction des valeurs de SoC modélisées (SoCm) grâce au modèle. Il apparaît que les valeurs de SoC déterminées par le procédé selon l'invention sont très proches du SoC réel.

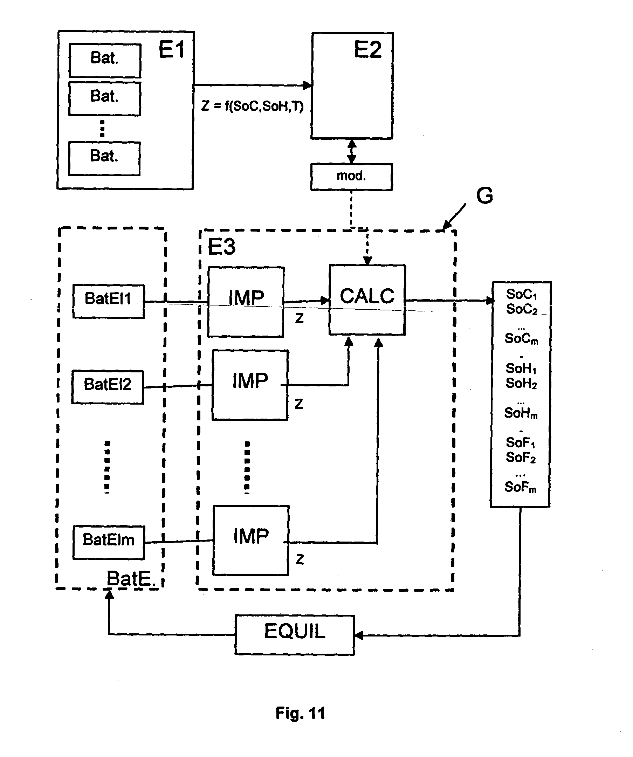

L'invention a été décrite dans le cadre d'une batterie constituant un pack de plusieurs cellules. On ne sortirait pas du cadre de l'invention lorsque le système électrochimique est un élément d'un pack (voir figure 11, où BatEl représente un élément du pack BatE. Et où l'indice 1, 2,...m fait référence respectivement à l'élément numéro 1, 2,...m).

En effet, les indicateurs existants de l'état interne des cellules reposent sur des mesures de courant, tension et température de peau réalisées sur chaque élément du pack.

Afin de gérer plus finement les performances d'un pack Li-ion, d'augmenter sa durée de vie et d'anticiper ses défauts, il peut être nécessaire de diagnostiquer également l'état d'un pack batterie Li-ion à bord d'un véhicule individuellement à l'échelle de chaque élément ou de quelques éléments bien choisis.

- La connaissance précise de l'état de charge (SoC) de chaque élément, selon le procédé de l'invention, permet un meilleur équilibrage (EQUIL sur la figure 11) du pack, sachant que la cellule la plus faible est limitante ; en outre, c'est à partir du SoC que la puissance disponible à chaque instant est calculée dans le système de gestion de la batterie (BMS).

- L'estimation de l'état de santé (SoH) de chaque élément, selon le procédé de l'invention, contribue également à un meilleur équilibrage du pack, donc une durée de vie accrue ; cet indicateur donne la capacité résiduelle de la batterie par rapport à l'état chargé à un instant t, ce qui évite de surdimensionner le pack initial, ou de le sous-utiliser.

- La détection d'une défaillance d'un élément (SoF "state of function"), selon le procédé de l'invention, permet de passer dans un fonctionnement en mode dégradé, en plaçant le module défaillant hors service, plutôt que d'aller jusqu'à un dysfonctionnement conduisant à un arrêt ou une dégradation de la batterie.

**Revendications**

1. Procédé d'estimation d'un état interne d'au moins un premier système électrochimique de stockage d'énergie électrique, dans lequel on estime au moins une propriété relative à l'état interne dudit premier système électrochimique à partir de mesures d'impédance électrochimique comportant les étapes suivantes :

   - pour différents états internes d'au moins un second système électrochimique d'un même type que ledit premier système électrochimique : - on mesure ladite propriété relative à l'état interne dudit second système; et - on mesure l'impédance électrochimique dudit second système électrochimique à au moins une fréquence ;
   **caractérisé en ce qu'**il comporte les étapes suivantes:
   - on définit un modèle d'impédance électrochimique en fonction de ladite propriété et de paramètres, et l'on calibre lesdits paramètres au moyen d'un ajustement sur lesdites mesures d'impédance électrochimique obtenues pour lesdits états internes ;
- on détermine une impédance électrochimique **Z** dudit premier système électrochimique pour au moins une fréquence ;
- on estime l'état interne dudit premier système électrochimique en estimant ladite propriété relative à l'état interne dudit système électrochimique au moyen dudit modèle et de ladite impédance électrochimique **Z**.

2. Procédé selon la revendication 1, dans lequel on estime ladite propriété relative à l'état interne dudit système électrochimique au moyen des étapes suivantes :

i. on choisit une valeur initiale pour ladite propriété ;
ii. on applique ledit modèle à ladite valeur initiale pour modéliser une impédance électrochimique **Zm** dudit premier système pour au moins une fréquence ;
iii. on ajuste ladite valeur de façon à ce que l'impédance électrochimique modélisée **Zm** corresponde à l'impédance électrochimique mesurée **Z**.

3. Procédé selon l'une des revendications précédentes, dans lequel on construit ledit modèle d'impédance électrochimique en réalisant les étapes suivantes :

i. on choisit une forme de courbe représentative de diagramme d'impédance obtenu sur un système électrochimique d'un même type que ledit premier système électrochimique ;
ii. on définit ledit modèle par une formule permettant de reproduire ladite forme de courbe.

4. Procédé selon la revendication 3, dans lequel on utilise un modèle du type:

$$\mathbf{Zm} = \mathbf{a} * \mathbf{i} * \omega + \mathbf{b} + \sum_{k=1}^{k=x} \frac{1}{c_k + d_k * i * \omega^{n_k}}$$

avec:

- Zm : impédance électrochimique
- $\omega$ : fréquence
- $\times$ : nombre de demi-cercles formés par ladite courbe
- a, b, $c_k$, $d_k$ et $n_k$ : paramètres du modèle à calibrer, dépendant de ladite propriété relative à l'état interne dudit premier système électrochimique.

5. Procédé selon l'une des revendications précédentes, dans lequel lesdits différents états internes sont obtenus en réalisant un vieillissement accéléré d'un second système électrochimique de stockage d'énergie électrique d'un même type que ledit premier système électrochimique.

6. Procédé selon l'une des revendications 1 à 4, dans lequel lesdits différents états internes sont obtenus en sélectionnant un ensemble de seconds systèmes électrochimiques du même type que ledit premier système électrochimique, lesdits systèmes dudit ensemble ayant des états internes différents.

7. Procédé selon l'une des revendications précédentes, dans lequel on calcule au moins l'une des propriétés relatives à l'état interne dudit système électrochimique suivantes : un état de charge (SoC) dudit système, un état de santé (SoH) dudit système.

8. Procédé selon l'une des revendications précédentes, dans lequel on détermine l'impédance électrochimique pour différentes fréquences en mesurant des diagrammes d'impédance électrique obtenue par ajout d'un signal électrique à un courant traversant ledit système électrochimique.

9. Procédé selon la revendication 8, dans lequel on mesure lesdits diagrammes d'impédance électrique en appliquant une perturbation sinusoïdale en courant sur ledit système électrochimique, et en mesurant une tension sinusoïdale induite aux bornes dudit système électrochimique.

10. Procédé selon la revendication 8, dans lequel on mesure lesdits diagrammes d'impédance électrique en appliquant une perturbation en courant sous la forme d'une superposition de plusieurs sinusoïdes ou sous la forme d'un bruit blanc, sur ledit système électrochimique, et en mesurant une tension sinusoïdale induite aux bornes dudit système électrochimique.

11. Procédé selon l'une des revendications précédentes, dans lequel on détermine l'impédance électrochimique pour différentes fréquences en mesurant des diagrammes d'impédance électrique obtenus au moyen d'un procédé non intrusif comportant un traitement du signal de tension et de courant en fonction du temps.

12. Procédé selon l'une des revendications précédentes, dans lequel ledit système électrochimique est en fonctionnement.

13. Procédé selon l'une des revendications précédentes, dans lequel ledit système électrochimique est une batterie ou un élément d'un pack.

14. Procédé selon l'une des revendications précédentes, dans lequel on détecte une défaillance d'au moins un élément d'un pack de batterie en déterminant l'état de fonctionnement (SoF) dudit élément dudit pack, en tant que propriété relative à l'état interne du système électrochimique.

15. Système d'estimation d'un état interne d'un système électrochimique de stockage d'énergie électrique, comportant au moins un capteur (G) incluant un moyen de mesure ou d'estimation d'impédance électrochimique Z pour au moins une fréquence dudit système électrochimique, **caractérisé en ce qu'**il comprend :

- une mémoire qui stocke un modèle d'impédance électrochimique en fonction d'une propriété relative à l'état interne du systèmes électrochimique, ledit modèle étant préalablement calibré au moyen de mesures d'impédance à au moins une fréquence pour différents états internes d'au moins un second système électrochimique d'un même type que ledit système électrochimique ;
- des moyens pour calculer ladite propriété relative à l'état interne dudit système électrochimique au moyen dudit modèle et de ladite impédance électrochimique Z.

16. Système intelligent de gestion ou de charge / décharge d'une batterie comportant un système d'estimation d'un état interne de ladite batterie selon la revendication 15.

**Patentansprüche**

1. Verfahren zur Bewertung eines internen Zustands mindestens eines ersten elektrochemischen Systems zur Speicherung elektrischer Energie, wobei mindestens eine Eigenschaft betreffend den internen Zustand des ersten elektrochemischen Systems anhand von Messungen der elektrochemischen Impedanz bewertet wird, welches folgende Schritte umfasst:

- bei verschiedenen internen Zuständen mindestens eines zweiten elektrochemischen Systems derselben Art wie das erste elektrochemische System: - wird die Eigenschaft betreffend den internen Zustand des zweiten Systems gemessen; und - es wird die elektrochemische Impedanz des zweiten elektrochemischen Systems bei mindestens einer Frequenz gemessen;
**dadurch gekennzeichnet, dass** es folgende Schritte aufweist:
- es wird ein Modell der elektrochemischen Impedanz in Abhängigkeit von dieser Eigenschaft und von Parametern festgelegt, und die Parameter werden mit Hilfe einer Anpassung an die Messungen der elektrochemischen Impedanz, die für die internen Zuständen erhalten werden, kalibriert;
- es wird eine elektrochemische Impedanz Z des ersten elektrochemischen Systems für mindestens eine Frequenz bestimmt;
- es wird der interne Zustand des ersten elektrochemischen Systems bewertet, indem die Eigenschaft betreffend den internen Zustand des elektrochemischen Systems mit Hilfe des Modells und der elektrochemischen Impedanz Z bewertet wird.

2. Verfahren nach Anspruch 1, wobei die Eigenschaft betreffend den internen Zustand des elektrochemischen Systems mit Hilfe folgender Schritte bewertet wird:

i. es wird ein Anfangswert für die Eigenschaft ausgewählt;
ii. das Modell wird auf den Anfangswert angewandt, um eine elektrochemische Impedanz Zm des ersten Systems für mindestens eine Frequenz modellhaft darzustellen;
iii. der Wert wird so eingestellt, dass die modellhaft dargestellte elektrochemische Impedanz Zm der gemessenen elektrochemischen Impedanz Z entspricht.

3. Verfahren nach einem der vorhergehenden Ansprüche, wobei das Modell der elektrochemischen Impedanz erstellt wird, indem folgende Schritt durchgeführt werden:

i. es wird eine repräsentative Kurve des Impedanzdiagramms ausgewählt, das bei einem elektrochemischen System der gleichen Art wie das erste elektrochemische System erhalten wird;
ii. das Modell wird durch eine Formel definiert, mit der die Form der Kurve nachgearbeitet werden kann.

4. Verfahren nach Anspruch 3, wobei ein Modell der folgenden Art verwendet wird:

$$Zm = a * i * \omega + b + \sum_{k=1}^{k=x} \frac{1}{c_k + d_k * i * \omega^{n_k}}$$

wobei:

- Zm : elektrochemische Impedanz
- $\omega$ : Frequenz
- $\times$ : Anzahl der von der Kurve gebildeten Halbkreise
- a, b, $c_k$, $d_k$ und $n_k$ :Parameter des zu kalibrierenden Modells, die von der Eigenschaft betreffend den internen Zustand des ersten elektrochemischen Systems abhängen.

5. Verfahren nach einem der vorhergehenden Ansprüche, wobei die verschiedenen internen Zustände erhalten werden, indem eine beschleunigte Alterung eines zweiten elektrochemischen Systems zur Speicherung elektrischer Energie derselben Art wie das erste elektrochemische System erfolgt.

6. Verfahren nach einem der Ansprüche 1 bis 4, wobei die verschiedenen internen Zustände erhalten werden, indem eine Gesamtheit von zweiten elektrochemischen Systemen derselben Art wie das erste elektrochemische System ausgewählt wird, wobei die Systeme der Gesamtheit verschiedene interne Zustände aufweisen.

7. Verfahren nach einem der vorhergehenden Ansprüche, wobei mindestens eine der folgenden Eigenschaften betreffend den internen Zustand des elektrochemischen Systems berechnet wird: ein Ladezustand (SoC) des Systems, ein Gesundheitszustand (SoH) des Systems.

8. Verfahren nach einem der vorhergehenden Ansprüche, wobei die elektrochemische Impedanz für verschiedene Frequenzen bestimmt wird, indem Diagramme der elektrischen Impedanz, die durch Hinzufügen eines elektrischen Signals A zu einem Strom, der das elektrochemische System durchquert, erzielt wird.

9. Verfahren nach Anspruch 8, wobei die Diagramme der elektrischen Impedanz gemessen werden, indem eine sinusförmige Stromstörung in dem elektrochemischen System angewandt wird und indem eine sinusförmige Spannung, die an den Anschlussklemmen des elektrochemischen Systems induziert wird, gemessen wird.

10. Verfahren nach Anspruch 8, wobei die Diagramme der elektrischen Impedanz gemessen werden, indem eine Stromstörung in Form einer Überlagerung mehrerer Sinuswellen oder in Form eines weißen Rauschens bei dem elektrochemischen System erfolgt und indem eine sinusförmige Spannung, die an den Anschlussklemmen des elektrochemischen Systems induziert wird, gemessen wird.

11. Verfahren nach einem der vorhergehenden Ansprüche, wobei die elektrochemische Impedanz für verschiedene Frequenzen bestimmt wird, indem Diagramme der elektrischen Impedanz gemessen werden, die mit Hilfe eines nicht eingreifenden Verfahrens, das eine Verarbeitung des Spannungs- und Stromsignals in Abhängigkeit von der Zeit enthält, erhalten werden.

**12.** Verfahren nach einem der vorhergehenden Ansprüche, wobei das elektrochemische System in Betrieb ist.

**13.** Verfahren nach einem der vorhergehenden Ansprüche, wobei das elektrochemische System eine Batterie oder ein Element eines Satzes ist.

**14.** Verfahren nach einem der vorhergehenden Ansprüche, wobei eine Störung mindestens eines Elements eines Batteriesatzes erfasst wird, indem der Betriebszustand (SoF) des Elements des Satzes als Eigenschaft betreffend den internen Zustand des elektrochemischen Systems bestimmt wird.

**15.** System zur Bewertung eines internen Zustands eines elektrochemischen Systems zur Speicherung von elektrischer Energie, das mindestens einen Sensor (G) aufweist, der ein Mittel zur Messung oder Bewertung der elektrochemischen Impedanz Z für mindestens eine Frequenz des elektrochemischen Systems umfasst, **dadurch gekennzeichnet, dass** es Folgendes umfasst:

- einen Speicher, der ein Modell der elektrochemischen Impedanz in Abhängigkeit von einer Eigenschaft betreffend den internen Zustand des elektrochemischen Systems speichert, wobei das Modell vorab kalibriert wird mit Hilfe von Impedanzmessungen bei mindestens einer Frequenz für verschiedene interne Zustände von mindestens einem zweiten elektrochemischen System derselben Art wie das elektrochemische System;
- Mittel zum Berechnen der Eigenschaft betreffend den internen Zustand des elektrochemischen Systems mit Hilfe des Modells und der elektrochemischen Impedanz Z.

**16.** Intelligentes System zur Steuerung und zur Ladung / Entladung einer Batterie, das ein System zur Bewertung eines internen Zustands der Batterie gemäß Anspruch 15 umfasst.

## Claims

**1.** A method of estimating an internal state of at least a first electrochemical system for electric power storage, wherein at least one property relative to the internal state of said first electrochemical system is estimated from electrochemical impedance measurements, comprising the following stages:

- for various internal states of at least a second electrochemical system of the same type as said first electrochemical system: measuring said property relative to the internal state of said second system; and - measuring the electrochemical impedance of said second electrochemical system at least at one frequency ;
**characterized in that** it comprises the following stages:
- defining an electrochemical impedance model as a function of said property and of parameters, and calibrating said parameters by means of an adjustment on said electrochemical impedance measurements obtained for said internal states ;
- determining an electrochemical impedance Z of said first electrochemical system for at least one frequency,
- estimating the internal state of said first electrochemical system by estimating said property relative to the internal state of said electrochemical system using said model and said electrochemical impedance Z.

**2.** A method as claimed in claim 1, wherein said property relative to the internal state of said electrochemical system is estimated by means of the following stages:

i. selecting an initial value for said property;
ii. applying said model to said initial value for modelling an electrochemical impedance Zm of said first system for at least one frequency;
iii. adjusting said value so that the modelled electrochemical impedance Zm corresponds to the measured electrochemical impedance Z.

**3.** A method as claimed in any one of the previous claims, wherein said electrochemical impedance model is constructed by carrying out the following stages:

i. selecting a representative impedance diagram curve shape obtained on an electrochemical system of the same type as said first electrochemical system;
ii. defining said model by a formula allowing to reproduce said curve shape.

4.  A method as claimed in claim 3, wherein a model of the type as follows is used:

$$Zm = a * i * \omega + b + \sum_{k=1}^{k=x} \frac{1}{c_k + d_k * i * \omega^{n_k}}$$

with:

- Zm : electrochemical impedance
- $\omega$ : frequency
- x : number of semi-circles formed by said curve
- a, b, $c_k$, $d_k$ and $n_k$ : parameters of the model to be calibrated, depending on said property relative to the internal state of said first electrochemical system.

5.  A method as claimed in any one of the previous claims, wherein said various internal states are obtained through accelerated aging of a second electrochemical system for electric power storage of the same type as said first electrochemical system.

6.  A method as claimed in any one of claims 1 to 4, wherein said various internal states are obtained by selecting a set of second electrochemical systems of the same type as said first electrochemical system, said systems of said set having different internal states.

7.  A method as claimed in any one of the previous claims, wherein at least one of the following properties relative to the internal state of said electrochemical system is calculated: a state of charge (SoC) of said system, a state of health (SoH) of said system.

8.  A method as claimed in any one of the previous claims, wherein the electrochemical impedance is determined for various frequencies by measuring electric impedance diagrams obtained by adding an electric signal to a current running through said electrochemical system.

9.  A method as claimed in claim 8, wherein said electric impedance diagrams are measured by applying a sinusoidal current perturbation to said electrochemical system and by measuring an induced sinusoidal voltage at the terminals of said electrochemical system.

10. A method as claimed in claim 8, wherein said electric impedance diagrams are measured by applying a current perturbation in form of a superposition of several sinusoids or in form of a white noise, on said electrochemical system, and by measuring an induced sinusoidal voltage at the terminals of said electrochemical system.

11. A method as claimed in any one of the previous claims, wherein the electrochemical impedance is determined for various frequencies by measuring electric impedance diagrams obtained using a non-invasive method comprising processing the voltage signal and the current signal as a function of time.

12. A method as claimed in any one of the previous claims, wherein said electrochemical system is in operation.

13. A method as claimed in any one of the previous claims, wherein said electrochemical system is a battery or an element of a pack.

14. A method as claimed in any one of the previous claims, wherein a failure of at least one element of a battery pack is detected by determining the state of function (SoF) of said element of said pack, as a property relative to the internal state of the electrochemical system.

15. A system of estimating an internal state of an electrochemical system for electric power storage, comprising at least one detector (G) including a means of measuring or estimating the electrochemical impedance Z for at least one frequency of said electrochemical system, **characterized in that** it comprises:

- a memory for storing an electrochemical impedance model as a function of a property relative to the internal state of the electrochemical system, said model being first calibrated by means of impedance measurements at one frequency at least for various internal states of at least a second electrochemical system of the same type as said electrochemical system;

- means for calculating said property relative to the internal state of said electrochemical system using said model and said electrochemical impedance Z.

16. A smart battery management or charge/discharge system comprising a system for estimating an internal state of said battery as claimed in claim 15.

Fig. 1

Fig. 2

**Fig. 3**

**Fig. 4**

Fig. 5A          Fig. 5B

Fig. 6

**Fig. 7**

**Fig. 8A**

**Fig. 8B**

**Fig. 9**

**Fig. 10**

Fig. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6191590 B1
- EP 1835297 A1
- US 20070035307 A1
- US 20070090843 A
- US 6778913 B2
- US 6037777 A
- EP 880710 A

- US 2004006440 A1
- US 2009096459 A1
- WO 9966340 A1
- WO 2009036444 A
- FR 2874701
- FR 1000778

**Littérature non-brevet citée dans la description**

- **U. TRÖLTZSCH et al.** *Electrochimica Acta,* 2006, vol. 51, 1664-1672